# EUROPEAN PATENT APPLICATION

(11) **EP 0 849 806 A2**
(43) Date of publication of application: **24.06.1998**
(21) Application number: 97310339.3
(22) Date of filing: 19.12.1997
(51) Int. Cl.: H01L 29/43

(54) **Improvements in or relating to semiconductor devices having tungsten nitride sidewalls**

(30) Priority: 19.12.1996 US 32444 P
(71) Applicant: Texas Instruments Incorporated, Dallas, Texas 75265 (US)
(72) Inventor: Cho, Chih-Chen, Richardson, TX 75082 (US)
(74) Representative: Holt, Michael

(57) **Abstract**

A semiconductor device is provided that includes a tungsten region (20) having tungsten nitride sidewalls (24). The semiconductor device includes a tungsten region (20) formed above a semiconductor substrate (10). Tungsten nitride sidewalls (24) are then formed on the tungsten region (20). The tungsten nitride sidewalls (24) provide a barrier for sides of the tungsten region (20).

## Description

### TECHNICAL FIELD OF THE INVENTION

This invention relates in general to the field of semiconductor devices and more particularly to a semiconductor devices having tungsten nitride sidewalls formed on tungsten regions and a method of construction.

### BACKGROUND OF THE INVENTION

Tungsten (W) is widely used in integrated circuits as a material for constructing device features such as first level metal, vias, contacts and gate electrodes. Tungsten is useful because of its high electro-migration resistance, ease to grow and etch, relatively high thermal stability and low electrical resistance. However, tungsten can react with silicon (Si) and aluminum (Al) when they are in direct contact. Furthermore, tungsten reacts with oxygen (O₂) or water (H₂O) and forms tungsten oxide (WO₃) at temperatures above 400 degrees Celsius. Tungsten oxide begins to vaporize at a temperature above 750 degrees Celsius. This can cause processing problems. Consequently, a diffusion barrier is often used above and below tungsten regions to prevent reactions between tungsten and the adjacent materials. Among other materials, tungsten nitride (WN_{X}) has been used to form diffusion barriers between tungsten regions and aluminum regions and between aluminum and silicon regions. In comparison with similar structures that use titanium nitride (TiN) as the barrier material, the tungsten nitride provides lower resistance and improved reliability.

### SUMMARY OF THE INVENTION

In accordance with the present invention, a semiconductor device having tungsten nitride sidewalls formed on tungsten regions and a method of construction are provided that substantially eliminates or reduces problems and disadvantages associated with previously developed tungsten regions and methods of construction.

According to one embodiment of the present invention, a semiconductor device is provided that includes a tungsten region having tungsten nitride sidewalls. The semiconductor device includes a lower barrier region formed above the semiconductor substrate where the lower barrier region restricts diffusion of tungsten. A tungsten region is formed above and adjacent to the lower barrier region. Tungsten nitride sidewalls are then formed on the tungsten region. The tungsten nitride sidewalls provide a barrier for sides of the tungsten region.

A technical advantage of the present invention is the use of nitridized tungsten (WN_{X}) for sidewalls on tungsten regions to provide a protection cap so that other processes, such as oxidization and film deposition, can be carried out without degrading the properties of the tungsten regions. Tungsten nitride (WN_{X)} is chemically more stable than tungsten oxide (WO₃₎ and tungsten (W).

Another technical advantage of the present invention is that tungsten nitride layers of sufficient thickness can be formed by nitridization reaction of tungsten in atmospheres that contain nitrogen (N₂) or ammonia (NH₃) atoms with or without plasma. Thus, formation processes for the tungsten nitride sidewalls do not affect the performance of other layers around tungsten regions. The sidewall formation is essentially a "selective" tungsten nitride formation process.

### BRIEF DESCRIPTION OF THE DRAWINGS

The present invention will now be further described by way of example, with reference to the accompanying drawings in which:
FIGURE 1 is a diagram of a cross-section of a semiconductor device having a tungsten region; and
FIGURE 2 is a diagram of a cross-section of the semiconductor device of FIGURE 1 having tungsten nitride sidewalls formed on the tungsten region.

### DETAILED DESCRIPTION OF THE INVENTION

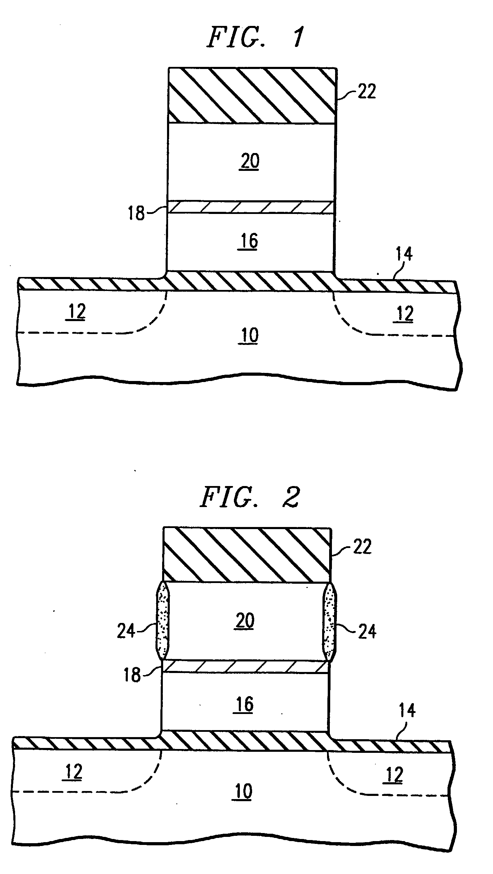

FIGURE 1 is a diagram of a cross-section of a semiconductor device having a tungsten region. In the embodiment of FIGURE 1, the semiconductor device includes a silicon substrate 10 which has doped regions 12 formed. An oxide layer 14 is formed above substrate 10, for example, from silicon dioxide (SiO₂). In the embodiment of FIGURE 1, a gate region structure is shown as formed above substrate 10. The gate region structure of FIGURE 1 includes a poly-silicon region 16 and a barrier region 18. Barrier region 18 can be formed, for example, from titanium nitride (TiN), tungsten nitride (WN), or titanium silicon nitride (WSiN). The gate region structure also includes a tungsten region 20 positioned above barrier region 18. An upper barrier region 22 is then formed above tungsten region 20, for example, from silicon nitride (Si₃N₄) or silicon dioxide (SiO₂).

FIGURE 2 is a diagram of a cross-section of the semiconductor device of FIGURE 1 having tungsten nitride (WN_{X}) sidewalls 24 formed on tungsten region 20. Tungsten nitride sidewalls 24 can be formed, for example, by chemical vapor deposition which is a non-selective process. Another process for forming tungsten nitride sidewalls 24 is the annealing of tungsten region 20 by furnace or rapid thermal process in an atmosphere that contains nitrogen atoms, such as nitrogen (N₂) or ammonia (NH₃). This process is a selective formation process. The effects of high temperature annealing (for example, 900 degrees Celsius for 30 seconds) on the surrounding materials may be beneficial or detrimental. A further method to selectively form tungsten nitride sidewalls 24 is to use a plasma treatment in an atmosphere that contains nitrogen atoms. In addition to its selectivity, this is a low temperature process. For example, with 60 seconds exposure time, six nanometers thick tungsten nitride sidewalls can be formed at a substrate temperature of 50 degrees Celsius by nitrogen plasma treatment.

It should be understood that FIGUREs 1 and 2 explain only one possible embodiment. For example, another embodiment is to use a tugnsten region 20 directly on a gate oxide 14 to form a tungsten gate. In this case, there is not a polysilicon region 16 and no need for a barrier region 18. Tungsten nitride sidewalls 24 are then formed on the tungsten region 20.

Tungsten/titanium nitride/poly-silicon structures have been widely considered as gate electrode materials because the sheet resistance of this structure is lower than that of conventional tungsten silicide/poly-silicon structures. However, it is often necessary to employ an oxidization process after the gate is patterned (for example, FIGURE 1), so that damage on the gate oxide that resulted from the previous etching process can be removed. Since the sidewall of tungsten region 20 is exposed during this oxide formation process, the possibility of forming tungsten oxide (WO₃) and thus degrading tungsten region 20 is a concern. Selective formation of tungsten nitride sidewalls (24) prevents the oxidization of tungsten region 20.

Although the certain embodiments have been described in detail, it should be understood that various changes, substitutions and alterations can be made thereto without departing from the spirit and scope of the teachings disclosed herein.

## Claims

1. A semiconductor device, comprising:
a tungsten region formed over a substrate; and
tungsten nitride sidewalls formed over the tungsten region, the tungsten nitride sidewalls being arranged to provide a barrier for a side of the tungsten region.

2. The semiconductor device of Claim 1, further comprising:
a lower barrier region formed over the substrate and below the tungsten region, the lower barrier region being arranged to restrict diffusion of tungsten; and
the tungsten region formed over and adjacent to the lower barrier region.

3. The semiconductor device of Claim 1 or Claim 2, wherein the tungsten nitride sidewalls are formed by high temperature annealing in an atmosphere that contains nitrogen atoms.

4. The semiconductor device of Claim 3, wherein the atmosphere contains nitrogen (N₂).

5. The semiconductor device of Claim 3 or Claim 4, wherein the atmosphere contains ammonia (NH₃).

6. The semiconductor device of Claim 1, wherein the tungsten nitride sidewalls are formed by a plasma treatment in an atmosphere that contains nitrogen atoms.

7. The semiconductor device of Claim 1, wherein the tungsten nitride sidewalls are formed by chemical vapor deposition.

8. The semiconductor device of any of Claims 1 to 7, wherein the tungsten region forms part of a gate region for a transistor device.

9. The semiconductor device of any of Claims 2 to 8, further comprising:
an oxide layer formed over the substrate and below the lower barrier layer;
a poly-silicon layer formed between the oxide layer and the lower barrier layer;
and an upper barrier layer formed over the tungsten region.

10. A method for fabricating a semiconductor device, comprising:
forming a tungsten region over a substrate; and
forming tungsten nitride sidewalls over the tungsten region, the tungsten nitride sidewalls being arranged to provide a barrier for a side of the tungsten region.

11. The method of Claim 10, further comprising:
forming a lower barrier region over the substrate and below the tungsten region, the lower barrier region being arranged to restrict diffusion of tungsten; and
forming the tungsten region over and adjacent to the lower barrier region.

12. The method of Claim 10 or Claim 11, wherein the step of forming tungsten nitride sidewalls is accomplished by high temperature annealing in an atmosphere that contains nitrogen atoms.

13. The method of Claim 12, wherein said step of annealing comprises annealing in an atmosphere that contains nitrogen (N₂).

14. The method of Claim 12, wherein said step of annealing comprises annealing in an atmosphere that contains ammonia (NH₃).

15. The method of Claim 10, wherein said step of forming the tungsten nitride sidewalls is accomplished using a plasma treatment in an atmosphere that contains nitrogen atoms.

16. The method of Claim 10, wherein said step of forming the tungsten nitride sidewalls is accomplished using chemical vapor deposition.

17. The method of any of Claims 10 to 16, further comprising forming the tungsten region as part of a gate region for a transistor device.

18. The method of any of Claims 10 to 17, further comprising:
forming an oxide layer over the substrate and below the barrier layer;
forming a poly-silicon layer between the oxide layer and the barrier layer;
and forming an upper barrier layer over the tungsten region.
